# EUROPEAN PATENT APPLICATION

(11) **EP 3 428 960 A2**
(43) Date of publication of application: **16.01.2019**
(21) Application number: 18183306.2
(22) Date of filing: 13.07.2018
(51) Int. Cl.: H01L 21/673

(54) **WAFER SUPPORTING APPARATUS**

(30) Priority: 14.07.2017 CN 201720856685 U
(71) Applicant: Beijing Juntai Innovation Technology Co., Ltd, 100176 Beijing (CN)
(72) Inventor: LONG, Yongdeng, Beijing, Beijing 100176 (CN); CHEN, Xiangang, Beijing, Beijing 100176 (CN); YANG, Miao, Beijing, Beijing 100176 (CN); YU, Cao, Beijing, Beijing 100176 (CN); ZHANG, Jinyan, Beijing, Beijing 100176 (CN); XU, Xixiang, Beijing, Beijing 100176 (CN)
(74) Representative: Nony

(57) **Abstract**

A wafer supporting apparatus includes: a first fixed plate and a second fixed plate, a first upper fixing rod and a second upper fixing rod, and a lower fixing rod parallel to and below the first upper fixing rod and the second upper fixing rod. Two ends of the first upper fixing rod are fixedly connected to the first fixed plate and the second fixed plate respectively. Two ends of the second upper fixing rod are fixedly connected to the first fixed plate and the second fixed plate respectively. Two ends of the lower fixing rod are fixedly connected to the first fixed plate and the second fixed plate respectively. The first upper fixing rod and the second upper fixing rod are each provided with a plurality of limiting columns each of which including a cylindrical body and a semispherical end.

## Description

### TECHNICAL FIELD

The present disclosure relates to a technical field of solar cells, and for example, relates to a wafer supporting apparatus.

### BACKGROUND

Solar cells produced by taking silicon as a substrate, such as conventional solar cells, solar cells having heterojunction with intrinsic thin layer (HJT), interdigitated back contact (IBC) solar cells, passivated-emitter-rear-locally-diffused (PERL) solar cells, heterojunction back contact (HBC) solar cells, and passivated emitter rear contact (PERC) solar cells, contain crystalline silicon in structures. The yield of silicon wafer products in cleaning, texturing and drying processes before passivation is a base to ensure the cost reduction and the product yield of an entire solar cell production line, and the improvement of the cleanliness of a surface of the silicon wafer is also a necessary premise to ensure the improvement of solar cell efficiency. Therefore, in a production process of the solar cells, design and selection of a tool for supporting the silicon wafer are especially important.

In a relevant technology, a silicon wafer limiting rod is arranged on a silicon wafer supporting apparatus used in texturing or cleaning the silicon wafer in a mass production line of the crystalline silicon, and the silicon wafer limiting rod is generally dentate. When the silicon wafer is taken out and place on the silicon wafer supporting apparatus, the surface of the silicon wafer is easily scratched by the tip of the dentate, thereby affecting a subsequent process and causing low efficiency and bad appearance.

In addition, the silicon wafer supporting apparatus is further provided with a supporting rod, and if the supporting rod is designed improperly, some regions of the silicon wafer are not well processed in texturing, cleaning or drying. For example, edge parts of the silicon wafer are not well textured or cleaned, or water stains occur on the edge parts of the silicon wafer.

### SUMMARY

The present disclosure provides a wafer supporting apparatus, so as to prevent the wafer from being scratched, thereby improving the product yield.

The wafer supporting apparatus provided by this disclosure includes a pair of fixed plates including a first fixed plate and a second fixed plate, an upper fixing rod and a lower fixing rod.

A first end of the upper fixing rod is fixedly connected to the first fixed plate, and a second end of the upper fixing rod is fixedly connected to the second fixed plate. A plurality of limiting columns are arranged on the upper fixing rod, and each which includes a cylindrical body and a semispherical end.

A first end of the lower fixing rod is fixedly connected to the first fixed plate, and a second end of the lower fixing rod is fixedly connected to the second fixed plate.

In an embodiment, the lower fixing rod is provided with a plurality of limiting slots.

In an embodiment, the lower fixing rod includes: a transverse plate and a plurality of clamping plates vertically fixed to the transverse plate respectively, and a limiting slot is formed by every two adjacent ones of the plurality of clamping plates.

In an embodiment, the lower fixing rod includes: a plate body and a plurality of limiting protrusions arranged on the plate body, and a limiting slot is formed between every two adjacent ones of the plurality of limiting protrusions.

In an embodiment, each of the plurality of limiting protrusions is semi-cylindrical.

In an embodiment, each of the plurality of limiting slots of the plate body is provided with overflow holes.

In an embodiment, a quantity of the limiting columns is within a range of 1-300.

In an embodiment, the first fixed plate and the second fixed plate are each provided with convection holes.

In an embodiment, the first fixed plate and the second fixed plate are each provided with a tool clamping slot, to facilitate lifting the wafer supporting apparatus.

The present application further provides a wafer supporting apparatus. The wafer supporting apparatus includes: a first fixed plate and a second fixed plate, a first upper fixing rod and a second upper fixing rod, and a lower fixing rod.

The first fixed plate and the second fixed plate are arranged oppositely.

The first upper fixing rod and the second upper fixing rod are arranged oppositely. A first end of the first upper fixing rod is fixedly connected to the first fixed plate, and a second end of the first upper fixing rod is fixedly connected to the second fixed plate. A first end of the second upper fixing rod is fixedly connected to the first fixed plate, and a second end of the second upper fixing rod is fixedly connected to the second fixed plate. The first upper fixing rod and the second upper fixing rod are each provided with a plurality of limiting columns, each of which includes a cylindrical body and a semispherical end.

The lower fixing rod is arranged below the first upper fixing rod and the second upper fixing rod. A first end of the lower fixing rod is fixedly connected to the first fixed plate, and a second end of the lower fixing rod is fixedly connected to the second fixed plate.

In an embodiment, two side edges of the wafer are respectively inserted between two adjacent limiting columns of the first upper fixing rod and between two adjacent limiting columns of the second upper fixing rod, and a bottom edge of the wafer is supported by the lower fixing rod.

In an embodiment, the lower fixing rod is parallel to the first upper fixing rod and the second upper fixing rod.

In an embodiment, the plurality of limiting columns arranged on the first upper fixing rod and the plurality of limiting columns arranged on the second upper fixing rod are same in quantity and are arranged in a one-to-one correspondence manner.

In an embodiment, the first upper fixing rod comprises two first upper fixing rods which are configured to fix a first side edge of a wafer, the second upper fixing rod comprises two second upper fixing rods which are configured to fix a second side edge of the wafer, a higher one of the two first upper fixing rods is arranged at a same height as a higher one of the two second upper fixing rods, and a lower one of the two first upper fixing rods is arranged at a same height as a lower one of the two second upper fixing rods.

In an embodiment, the lower fixing rod is provided with a plurality of limiting slots.

In an embodiment, a width of each of the plurality of limiting slots is greater than a thickness of the wafer.

In an embodiment, the width of each of the limiting slots is within a range of 3-5 times of the thickness of the wafer.

In an embodiment, the lower fixing rod is cylindrical, and each of the plurality of limiting slots is formed by slotting in the lower fixing rod.

In an embodiment, a length of each of the plurality of limiting slots is less than or equal to a diameter of the lower fixing rod, and a depth of each of the plurality of limiting slots is less than or equal to a radius of the lower fixing rod.

In an embodiment, the lower fixing rod includes: a plate body and a plurality of limiting protrusions arranged on the plate body, and wherein every two adjacent ones of the plurality of limiting protrusions are provided with a limiting slot disposed therebetween.

In an embodiment, each of the plurality of limiting protrusions is semi-cylindrical.

In an embodiment, each of the plurality of limiting slots of the lower fixing rod is provided with an overflow hole formed thereon.

In an embodiment, a quantity of the limiting columns is within a numeral range of 1-300.

In an embodiment, the first fixed plate and the second fixed plate are each provided with convection holes.

In an embodiment, the first fixed plate and the second fixed plate are each provided with a tool clamping slot, to facilitate lifting the wafer supporting apparatus.

In an embodiment, the first upper fixing rod and the second upper fixing rod are cylindrical.

The wafer supporting apparatus provided by the present application may avoid scratching the wafer by configuring the main body of the limiting column to be cylindrical and configuring the end to be semispherical, thereby improving the product yield.

### BRIEF DESCRIPTION OF DRAWINGS

FIG. 1 is a top view of a wafer supporting apparatus provided by an embodiment;
FIG. 2 is an enlarged drawing illustrating a region A in FIG. 1;
FIG. 3 is a top view of a wafer supporting apparatus provided by another embodiment;
FIG. 4 is a perspective view of a wafer supporting apparatus provided by an embodiment;
FIG. 5 is a front view of a lower fixing rod provided by an embodiment;
FIG. 6 is a top view of the lower fixing rod shown in FIG. 5;
FIG. 7 is a front view of a lower fixing rod provided by another embodiment;
FIG. 8 is a top view of the lower fixing rod shown in FIG. 7;
FIG. 9 is a top view of overflow holes formed in the lower fixing rod shown in FIG. 5;
FIG. 10 is a side view of a first fixed plate provided by an embodiment; and
FIG. 11 is a top view of a wafer supporting apparatus provided by another embodiment.

### Lift of reference numerals

1a-first fixed plate; 1b-second fixed plate; 11-tool clamping slot; 2-upper fixing rod; 2a-first upper fixing rod; 2b-second upper fixing rod; 21-limiting column; 3-lower fixing rod; 31-limiting slot; 32-limiting protrusion; 33-overflow hole; 34-plate body; 4-convection hole; 5-pressing rod.

### DETAILED DESCRIPTION

Embodiments of the present disclosure are described low. Example of embodiments are shown in drawings, and same or similar numerals represent same or similar elements throughout or elements with same or similar functions. Embodiments described below with reference to drawings are exemplary, are only for explaining the present disclosure, and shall not be explained as a limitation to the disclosure.

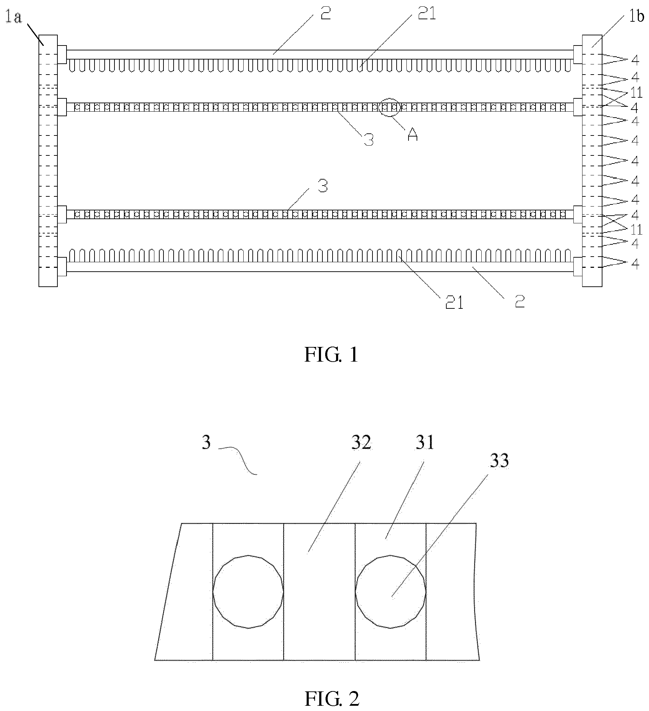

FIG. 1 is a top view of a wafer supporting apparatus provided by an embodiment, and FIG. 2 is an enlarged drawing illustrating a region A in FIG. 1.

As shown in FIG. 1, the wafer supporting apparatus provided by the present embodiment includes: a pair of fixed plates used as support structures. The pair of fixed plates includes a first fixed plate 1a and a second fixed plate 1b. The wafer supporting apparatus further includes one or more upper fixing rods 2 and one or more lower fixing rods 3. The upper fixing rods 2 and the lower fixing rods 3 may be arranged in pairs, and may be cylindrical. The wafer supporting apparatus may be used for a silicon wafer, a germanium wafer, a SiGe wafer, a glass wafer, a SiC wafer and the like.

By referring to FIG. 1 and FIG. 2, a first end of each upper fixing rod 2 is fixedly connected to the first fixed plate 1a, and a second end of each upper fixing rod 2 is fixedly connected to the second fixed plate 1b. Each upper fixing rod 2 is provided with a plurality of limiting columns 21 for limiting a first end of the silicon wafer, and each of the plurality of limiting columns 21 includes a cylindrical body and a semispherical end. A first end of each lower fixing rod 3 is fixedly connected to the first fixed plate 1a, and a second end of each lower fixing rod 3 is fixedly connected to the second fixed plate 1b. Multiple limiting columns 21 are arranged. In the present embodiment, the quantity of the limiting columns 21 may be designed to a number within 1-300 according to an overall size of the supporting apparatus.

When the silicon wafer is cleaned, the second ends of the silicon wafers are placed on the lower fixing rod 3. In an embodiment, each lower fixing rod 3 is provided with a plurality of limiting slots 31 for limiting the second end of the silicon wafer. In this way, the second ends of the silicon wafers may be placed in the limiting slots 31, and the first ends of the silicon wafers are each placed between two adjacent limiting columns 21. The main body of each of the plurality of limiting columns 21 is cylindrical and the end is semispherical, thereby avoiding the scratch of the silicon wafer, and improving the product yield.

The structures of the limiting slots 31 have several forms. In one implementation, the lower fixing rod 3 includes a transverse plate and a plurality of clamping plates vertically fixed to the transverse plate, and every two adjacent clamping plates of the plurality of clamping plates make up a limiting slot.

By referring to FIG. 2, as one implementation, the limiting slots 31 may be formed by configuring a plurality of limiting protrusions 32. In an embodiment, the limiting slots 31 are slotted in the cylindrical lower fixing rod 3 to form the plurality of limiting protrusions 32 and the plurality of limiting slots 31. A length of each of the plurality of limiting slots 31 is less than or equal to a diameter of the lower fixing rod 3, a depth of each of the plurality of limiting slots 31 is less than or equal to a radius of the lower fixing rod 3, and the depth of each of the plurality of limiting slots 31 is at least 5 mm.

In an embodiment, the lower fixing rod 3 includes a plate body and a plurality of limiting protrusions 32 formed on the plate body, and every two adjacent limiting protrusions 32 of the plurality of limiting protrusions 32 make up one limiting slot 31.

To further prevent the silicon wafer from being scratched, in an embodiment, the limiting protrusions 32 are configured to be semi-cylindrical. It may be understood that, the limiting protrusions 32 may also be in other shapes, and as long as fillets are arranged on the limiting protrusions 32, the scratch of the silicon wafer may be avoided.

Based on above embodiments, in the wafer supporting apparatus provided by the present embodiment, each limiting slot 31 of the plate body is provided with an overflow hole 33. The overflow holes 33 may enhance the flowing of liquid or gas, thereby reducing poor cleanliness of the silicon wafer due to that some regions of the silicon wafer are not well processed during cleaning, texturing or drying. Meanwhile, the overflow holes 33 can avoid accumulating solution in the limiting slots 31 after a process step is completed and the supporting device is lifted, and accelerate discharge of the solution. Moreover, when the silicon wafers are placed into a cleaning solution with the supporting apparatus, bubbles are generated in the solution when the solution flows through the overflow holes 33. As a result, the air in the solution moves to the limiting slots 31 where the silicon wafers are placed, and the silicon wafer is swung to left and right in the limiting slots 31. Compared with a relevant technology in which the silicon wafers are in a stationary state, a phenomenon of generating traces of the wafer supporting apparatus is avoided.

By continuing to refer to FIG. 1, in an embodiment, the first fixed plate 1a and the second fixed plate 1b are each provided with convection holes 4, to strengthen the flowing of the liquid and the gas, improve the uniformity of the solution or the gas, and facilitate improving the cleaning, texturing or drying effect.

In an embodiment, the first fixed plate 1a and the second fixed plate 1b are each provided with a tool clamping slot 11 arranged at an upper end of the first fixed plate 1a and an upper end of the second fixed plate 1b respectively, to facilitate lifting the wafer supporting apparatus.

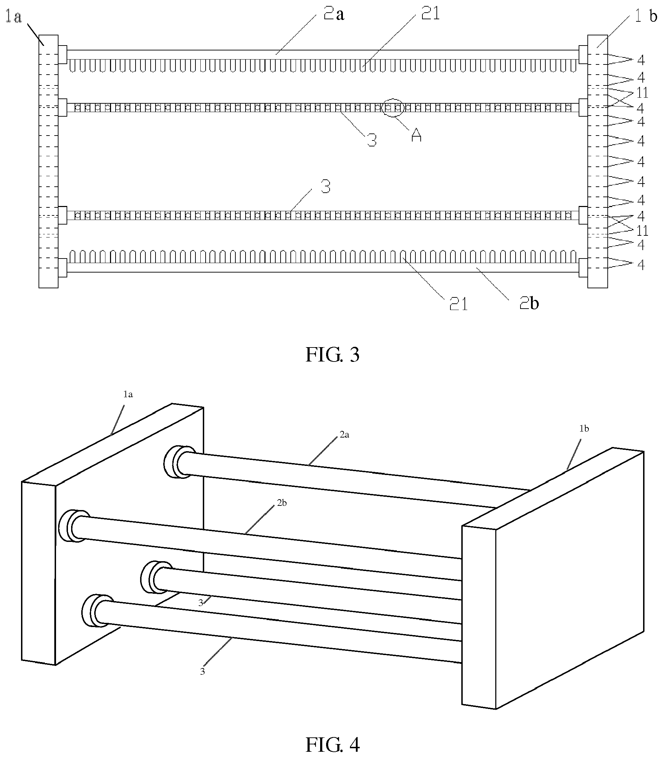

FIG. 3 is a top view of another wafer supporting apparatus provided by the present embodiment. FIG. 4 is a perspective view of the wafer supporting apparatus shown in FIG. 3. FIG. 4 only illustrates the first fixed plate 1a, the second fixed plate 1b, the first upper fixing rod 2a, the second upper fixing rod 2b and the lower fixing rod 3, and does not illustrate the limiting column 21 and other structures in FIG. 3. By referring to FIG. 3, and FIG. 4, the wafer supporting apparatus provided by the present embodiment includes: a first fixed plate 1a and a second fixed plate 1b arranged oppositely, a first upper fixing rod 2a and a second upper fixing rod 2b arranged oppositely, and one or more lower fixing rods 3 (taking two lower fixing rods 3 as an example in FIG. 1). A first end of the first upper fixing rod 2a is fixedly connected to the first fixed plate 1a, and a second end of the first upper fixing rod 2a is fixedly connected to the second fixed plate 1b. A first end of the second upper fixing rod 2b is fixedly connected to the first fixed plate 1a, and a second end of the second upper fixing rod 2b is fixedly connected to the second fixed plate 1b. The first upper fixing rod 2a and the second upper fixing rod 2b are each provided with a plurality of limiting columns 21, and each of the plurality of limiting columns 21 includes a cylindrical body and a semispherical end. The lower fixing rods 3are arranged below the first upper fixing rod 2a and the second upper fixing rod 2b. First ends of the lower fixing rods 3 are fixedly connected to the first fixed plate 1a, and second ends of the lower fixing rods 3 are fixedly connected to the second fixed plate 1b.

In an embodiment, two side edges of the silicon wafer are respectively inserted between two adjacent limiting columns 21 of the first upper fixing rod 2a and between two adjacent limiting columns 21 of the second upper fixing rod 2b, and a bottom edge of the silicon wafer is supported by the lower fixing rod 3.

In an embodiment, the first upper fixing rod 2a is parallel to the second upper fixing rod 2b, and the lower fixing rod 3 is parallel to the first upper fixing rod 2a and the second upper fixing rod 2b and located below the first upper fixing rod 2a and the second upper fixing rod 2b.

In an embodiment, the first fixed plate 1a and the second fixed plate 1b may be configured in any shape, as long as the first fixed plate 1a and the second fixed plate 1b may support the first upper fixing rod 2a, the second upper fixing rod 2b and the lower fixing rod 3. For example, the first fixed plate 1a and the second fixed plate 1b may be cuboid or cylindrical, and may be in other shapes.

In an embodiment, the limiting columns 21 arranged on the first upper fixing rod 2a and the limiting columns 21 arranged on the second upper fixing rod 2b have the same quantity and are arranged in a one-to-one correspondence manner.

In an embodiment, the first upper fixing rod 2a has a same structure as the second upper fixing rod 2b, and the side of the first upper fixing rod 2a where the limiting columns 21 are arranged is opposite to the side of the second upper fixing rod 2b where the limiting columns 21 are arranged.

In an embodiment, the quantity of the first upper fixing rod 2a may be one or more, and the quantity of the second upper fixing rod 2b may be one or more.

In an embodiment, the first upper fixing rod 2a has the same quantity as the second upper fixing rod 2b. For example, the first upper fixing rod 2a includes two first upper fixing rods 2a fixed at a same side, and the two first upper fixing rods 2a are arranged along a vertical direction; the second upper fixing rod 2b includes two second upper fixing rods 2b fixed at a same side, and the two second upper fixing rods 2b are arranged along the vertical direction. The first edge of the silicon wafer is fixed through the two first upper fixing rods 2a, and the second edge of the silicon wafer is fixed through the two second upper fixing rods 2b, thereby the silicon wafer being fixed more stably.

In an embodiment, the first upper fixing rod 2a includes two upper fixing rods 2a and the second upper fixing rod 2b includes two second upper fixing rods 2b. One of the two first upper fixing rods 2a is disposed higher than the other one of the two first upper fixing rods 2a. One of the two second upper fixing rods 2b is disposed higher than the other one of the two second upper fixing rods 2b. The first edge of the silicon wafer is fixed through the two first upper fixing rods 2a, and the second edge of the silicon wafer is fixed through the two second upper fixing rods 2b, such that the silicon wafer is fixed more stably. In an embodiment, the higher one of the two first upper fixing rods 2a corresponds to the higher one of the two second upper fixing rods 2b, and arranged at a same height as the higher one of the two second upper fixing rods 2b, the lower one of the two first upper fixing rods 2a corresponds to the lower one of the two second upper fixing rods 2b, and arranged at a same height as the lower one of the two second upper fixing rods 2b.

In an embodiment, the quantity of the lower fixing rod 3 may be one or more, and the bottom edge of the silicon wafer is supported through the one or more lower fixing rods 3.

When the silicon wafer is supported by the wafer supporting apparatus, a first edge of the silicon wafer is placed between the two adjacent limiting columns 21 of the first upper fixing road 2a, and a second side edge of the silicon wafer opposed to the first edge is placed between the two adjacent limiting columns 21 of the second upper fixing rod 21b, so that the first edge and the second edge of the silicon wafer are fixed through the first upper fixing rod 2a and the second upper fixing rod 2b. The bottom edge of the silicon wafer adjacent to the first side edge and the second side edge is placed on the lower fixing rod 3, and thus is supported through the lower fixing rod 3. Thus, the silicon wafer is supported.

Since the main body of the limiting column 21 is cylindrical and the end is semispherical, the silicon wafer is hardly scratched by the wafer supporting apparatus and the product yield is improved.

In an embodiment, the quantity of the limiting columns 21 may be set according to an overall size of the wafer supporting apparatus, and the quantity of the silicon wafers supported by the wafer supporting apparatus at one time is determined by the quantity of the limiting columns 21. In an embodiment, the quantity of the limiting columns 21 is within a range of 1-300.

In an embodiment, the lower fixing rod 3 is provided with a plurality of limiting slots 31 formed thereon. The bottom edge of the silicon wafer is placed in the limiting slot 31.

In an embodiment, the depth of each of the limiting slots 31 is greater than or equal to 5 mm, to prevent the silicon wafer from falling from the limiting slots 31.

In an embodiment, the width of each of the limiting slots 31 is greater than the thickness of the silicon wafer.

In an embodiment, the width of each of the limiting slots 31 is within the range of 3-5 times of the thickness of the silicon wafer.

The limiting slots 31 can be implemented through several modes, and will be illustrated by examples below.

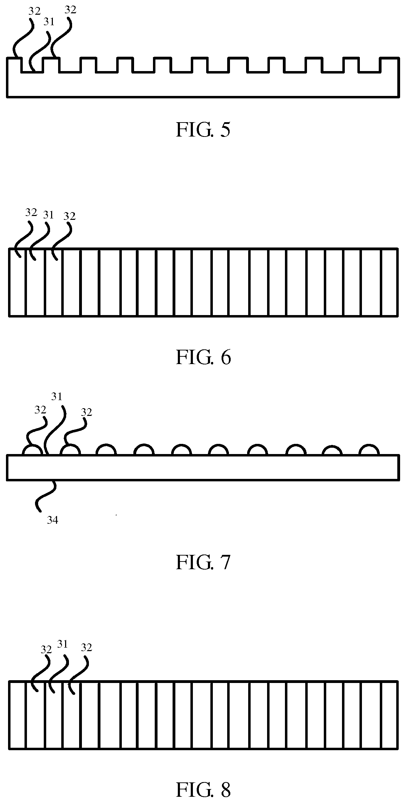

FIG. 5 is a front view of the lower fixing rod provided by the present embodiment, and FIG. 6 is a top view of the lower fixing rod shown in FIG. 5. As shown in FIG. 5 and FIG. 6, in an embodiment, the lower fixing rod 3 is cylindrical; each of the limiting slots 31 is formed by slotting in the lower fixing rod 31; and every two adjacent limiting slots 31 spaced apart by a limiting protrusion 32 formed therebetween.

In an embodiment, the length of each of the plurality of limiting slots 31 is less than or equal to the diameter of the lower fixing rod 3, and the depth of each of the plurality of limiting slots 31 is less than or equal to the radius of the lower fixing rod 3.

FIG. 7 is a front view of another lower fixing rod provided by the present embodiment, and FIG. 8 is a top view of the lower fixing rod shown in FIG. 7. As shown in FIG. 7 and FIG. 8, in an embodiment, the lower fixing rod 3 includes a plate body 34 and a plurality of limiting protrusions 32. The plurality of limiting protrusions 32 are arranged on the plate body 34, and every two adjacent limiting protrusions 32 of the plurality of limiting protrusions 32 make up a limiting slot 31.

In an embodiment, the limiting protrusions 32 are semi-cylindrical.

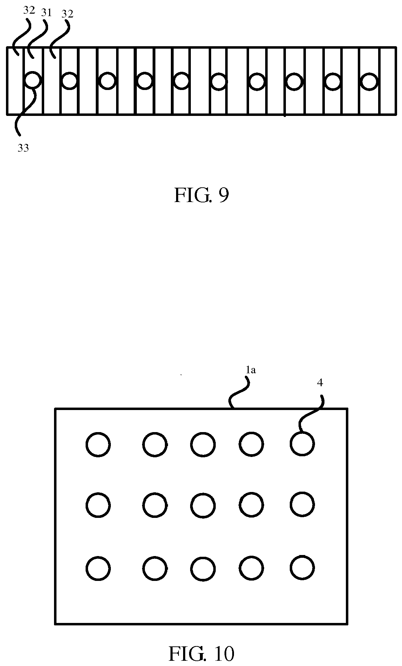

In an embodiment, each limiting slot 31 of the lower fixing rod 3 is provided with overflow holes 33. For example, each limiting slot 31 of the lower fixing rod 3 is formed with the overflow holes 33 as shown in FIG. 5, and a top view of which is shown in FIG. 9. The overflow holes 33 may enhance the flowing of liquid or gas, thereby reducing the poor cleanliness of the silicon wafer due to a dead zone of the silicon wafer during cleaning, texturing or drying. Meanwhile, after a process step is completed and the wafer supporting apparatus is lifted, the overflow holes 33 may avoid residual solution in the limiting slots 31, and accelerate discharge of the solution. Moreover, when the silicon wafers are placed into a cleaning solution with the supporting apparatus, bubbles are generated in the solution when the solution flows through the overflow holes 33. As a result, the air in the solution moves to the limiting slots 31 where the silicon wafers are placed, and the silicon wafer is swung to left and right in the limiting slots 31. Compared with a relevant technology in which the silicon wafers are in a stationary state, a phenomenon of generating traces of the wafer supporting apparatus is avoided.

FIG. 10 is a side view of a first fixed plate provided by the present embodiment. The side view of the second fixed plate is the same as the side view of the first fixed plate. As shown in FIG. 10, in an embodiment, the first fixed plate 1a and the second fixed plate 1b are each provided with convection holes 4.

In an embodiment, the first fixed plate 1a and the second fixed plate 1b are each formed with multiple convection holes 4.

In an embodiment, the shape and the position of the convection holes 4 may be configured arbitrarily. For example, a cross section of the convection hole 4 may be circular, square, triangular, and may be in other shapes.

In an embodiment, the first fixed plate 1a and the second fixed plate 1b are each provided with a tool clamping slot, to facilitate lifting the wafer supporting apparatus.

In an embodiment, the tool clamping slots may be respectively arranged at a top surface of the first fixed plate 1a and a top surface of the second fixed plate 1b, or respectively arranged on a side surface of the first fixed plate 1a opposed to a side surface connected to the first end of the first upper fixing rod 2a and on a side surface of the second fixed plate 1b opposed to a side surface connected to the second end of the first upper fixing rod 2a.

In an embodiment, the height of the tool clamping slot in the first fixed plate 1a is consistent with the height of the tool clamping slot in the second fixed plate 1b.

In an embodiment, the first upper fixing rod 2a and the second upper fixing rod 2b are cylindrical.

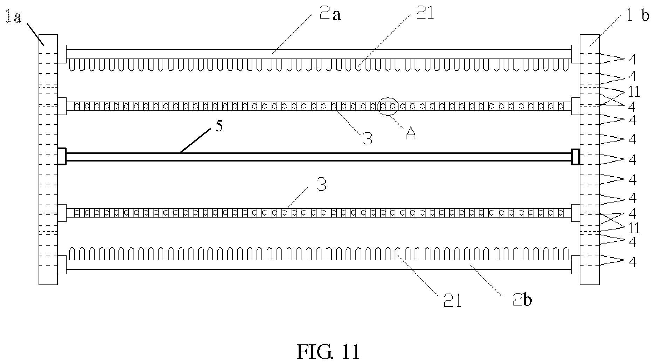

FIG. 11 is a top view of another wafer supporting apparatus provided by the present embodiment. As show in FIG. 10, in an embodiment, to better fix the silicon wafer, the wafer supporting apparatus may further include a pressing rod 5. A first end of the pressing rod 5 is fixedly connected to the first fixed plate 1a, and a second end of the pressing rod 5 is fixedly connected to the second fixed plate 1b. A top edge of the silicon wafer opposed to the bottom edge is fixed by the pressing rod 5.

In an embodiment, the pressing rod 5 is provided with a plurality of limiting slots 31, and a fourth side (that is, the top edge) of the silicon wafer is placed in the limiting slot 31 of the pressing rod 5.

Above embodiments shown according to drawings illustrate structures, features and effect of the present disclosure, and the above only describes embodiments of the present disclosure.

## Claims

1. A wafer supporting apparatus, comprising:
a first fixed plate (1a) and a second fixed plate (1b) opposite to each other;
a first upper fixing rod (2a) and a second upper fixing rod (2b) opposite to each other, wherein a first end of the first upper fixing rod (2a) is fixedly connected to the first fixed plate (1a), and a second end of the first upper fixing rod (2a) is fixedly connected to the second fixed plate (1b); a first end of the second upper fixing rod (2b) is fixedly connected to the first fixed plate (1a), and a second end of the second upper fixing rod (2b) is fixedly connected to the second fixed plate (1b); and the first upper fixing rod (2a) and the second upper fixing rod (2b) are each provided with a plurality of limiting columns (21) each of which comprises a cylindrical body and a semispherical end; and
a lower fixing rod (3), wherein the lower fixing rod (3) is arranged below the first upper fixing rod (2a) and the second upper fixing rod (2b), a first end of the lower fixing rod (3) is fixedly connected to the first fixed plate (1a), and a second end of the lower fixing rod (3) is fixedly connected to the second fixed plate (1b).

2. The wafer supporting apparatus according to claim 1, wherein the plurality of limiting columns (21) arranged on the first upper fixing rod (2a) and the plurality of limiting columns (21) arranged on the second upper fixing rod (2b) are same in quantity and are arranged in a one-to-one correspondence manner.

3. The wafer supporting apparatus according to claim 1 or claim 2, wherein the first upper fixing rod (2a) comprises two first upper fixing rods (2a) which are configured to fix a first side edge of a wafer, the second upper fixing rod (2b) comprises two second upper fixing rods (2b) which are configured to fix a second side edge of the wafer, a higher one of the two first upper fixing rods (2a) is arranged at a same height as a higher one of the two second upper fixing rods (2b), and a lower one of the two first upper fixing rods (2a) is arranged at a same height as a lower one of the two second upper fixing rods (2b).

4. The wafer supporting apparatus according to any one of claims 1 to 3, wherein the lower fixing rod (3) is provided with a plurality of limiting slots (31).

5. The wafer supporting apparatus according to claim 4, wherein a width of each of the plurality of limiting slots (31) is greater than a thickness of the wafer.

6. The wafer supporting apparatus according to claim 5, wherein the width of each of the limiting slots is (31) within a range of 3-5 times of the thickness of the wafer.

7. The wafer supporting apparatus according to any one of claims 4 to 6, wherein the lower fixing rod (3) is cylindrical, and each of the plurality of limiting slots (31) is formed by slotting in the lower fixing rod (3).

8. The wafer supporting apparatus according to claim 7, wherein a length of each of the plurality of limiting slots (31) is less than or equal to a diameter of the lower fixing rod (3), and a depth of each of the plurality of limiting slots (31) is less than or equal to a radius of the lower fixing rod (3).

9. The wafer supporting apparatus according to any one of claims 4 to 6, wherein the lower fixing rod (3) comprises: a plate body (34) and a plurality of limiting protrusions (32) arranged on the plate body (34), and wherein every two adjacent ones of the plurality of limiting protrusions (32) are provided with a limiting slot (31) disposed therebetween.

10. The wafer supporting apparatus according to claim 9, wherein each of the plurality of limiting protrusions (32) is semi-cylindrical.

11. The wafer supporting apparatus according to any one of claims 4-10, wherein each of the plurality of limiting slots (31) of the lower fixing rod (3) is provided with an overflow hole (33) formed thereon.

12. The wafer supporting apparatus according to any one of claims 1-11, wherein a quantity of the limiting columns (21) is within a numeral range of 1-300.

13. The wafer supporting apparatus according to any one of claims 1-12, wherein the first fixed plate (1a) and the second fixed plate (1b) are each provided with convection holes (4).

14. The wafer supporting apparatus according to any one of claims 1-13, wherein the first fixed plate (1b) and the second fixed plate (1b) are each provided with a tool clamping slot (11), to facilitate lifting the wafer supporting apparatus.

15. The wafer supporting apparatus according to any one of claims 1-14, wherein the first upper fixing rod (2a) and the second upper fixing rod (2b) are cylindrical.
